(19) Europäisches Patentamt
European Patent Office
Office européen des brevets

(11) Publication number: **0 536 743 A1**

(12) # EUROPEAN PATENT APPLICATION

(21) Application number: **92117192.2**

(22) Date of filing: **08.10.92**

(51) Int. Cl.5: **C08F 299/00**, C08F 299/06, C08F 265/04, C03C 25/02, //(C08F265/04,230:08)

(30) Priority: **08.10.91 JP 260356/91**

(43) Date of publication of application: **14.04.93 Bulletin 93/15**

(84) Designated Contracting States: **DE ES FR GB IT**

(71) Applicant: **SUMITOMO ELECTRIC INDUSTRIES, LTD**
**5-33, Kitahama 4-chome, Chuo-ku**
**Osaka-shi, Osaka-fu(JP)**

(72) Inventor: **Mishima, Takayuki, c/o Osaka Works of**
**Sumitomo Elec. Ind., Ltd., 1-3, Shimaya 1-chome**
**Konohana-ku, Osaka-shi, Osaka-fu(JP)**
Inventor: **Nishimoto, Hiroaki, c/o Osaka Works of**
**Sumitomo Elec. Ind., Ltd., 1-3, Shimaya 1-chome**
**Konohana-ku, Osaka-shi, Osaka-fu(JP)**
Inventor: **Yamanaka, Hiroshi, c/o Osaka Works of**
**Sumitomo Elec. Ind., Ltd., 1-3, Shimaya 1-chome**
**Konohana-ku, Osaka-shi, Osaka-fu(JP)**
Inventor: **Okumi, Shinsuke, c/o Osaka Works of**
**Sumitomo Elec. Ind., Ltd., 1-3, Shimaya 1-chome**
**Konohana-ku, Osaka-shi, Osaka-fu(JP)**

(74) Representative: **Hansen, Bernd, Dr. Dipl.-Chem. et al**
**Hoffmann, Eitle & Partner Patent- und Rechtsanwälte Arabellastrasse 4 Postfach 81 04 20**
**W-8000 München 81 (DE)**

(54) **Resin composition and plastic clad optical fiber comprising the same.**

(57) A resin composition containing an ultraviolet-curing resin and a reactive compound that contains at least one silicon atom to which an alkoxy group or a halogen atom is bonded, and at least two functional groups capable of forming a chemical bond to the ultraviolet-curing resin in a molecule is disclosed. A cured material of the resin composition can be used as a cladding of a plastic clad optical fiber having high bond strength between the core and the cladding.

EP 0 536 743 A1

## BACKGROUND OF THE INVENTION

### Field of the invention

The present invention relates to a resin composition and a plastic clad optical fiber which is clad with a cured material of said resin composition. The resin composition according to the present invention is a photosetting resin, particularly an ultraviolet-curing resin.

### Description of related art

An ultraviolet-curing fluorinated acrylate is preferably used as a cladding material of a polymer clad optical fiber, since a cured material of the fluorinated acrylate has good mechanical strength and low light transmission loss. However, when an uncured resin is coated on a glass core and then irradiated by ultraviolet light to cure the resin, a gap is formed between the core and the cladding so that the light transmission loss increases and the tensile strength of the optical fiber decreases. Since the bond strength between the core and the cladding is low, it is impossible to obtain sufficient pull-out strength between the fiber and a connector after the connector is attached to the fiber.

In order to solve the above problems, Japanese Patent Kokai Publication No. 24203/1989 proposes to add, to a composition for forming a cladding, a compound having one ultraviolet sensitive functional group and a silicon atom to which at least one alkoxy group or halogen atom is bonded in a molecule of the formula:

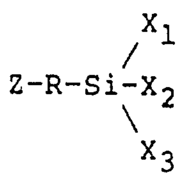

(A)

wherein Z is a functional group capable of forming a chemical bond to an ultraviolet-curing resin by ultraviolet irradiation,
at least one of $X_1$ to $X_3$ is an alkoxy group or a halogen atom, and each of the rest of $X_1$ to $X_3$ is an alkyl or fluoroalkyl group, and
R is a single bond or a divalent organic group connecting the Z group with the Si atom,
as a compound for forming a chemical bond between the glass core and the polymer cladding.

However, this prior art does not sufficiently solve the problem of low bond strength between the core and the cladding after the curing. This may be because the compound which is added to the cladding has only one functional group for forming a chemical bond to the ultraviolet-curing resin.

## SUMMERY OF THE INVENTION

An object of the present invention is to provide a plastic clad optical fiber having sufficiently high bond strength between a core and a cladding.

This or other objects of the present invention are achieved by a resin composition comprising an ultraviolet-curing resin, and a reactive compound that has at least one silicon atom to which an alkoxy group or a halogen atom is bonded, and at least two functional groups capable of forming a chemical bond to the ultraviolet-curing resin in a molecule.

The present invention provides a plastic clad optical fiber comprising a core made of quartz or optical glass and a cladding made of a plastic having a lower refractive index than the core,
wherein the cladding is made of a cured material of said resin composition.

## DETAILED DESCRIPTION OF THE INVENTION

The resin composition according to the present invention comprises the reactive compound and the ultraviolet-curing resin. The resin composition according to the present invention may contain (meth)acrylic acid.

The alkoxy group in the reactive compound is preferably $-OCH_3$, $-OCH_2CH_3$, $-OCH_2CH_2CH_3$ or $-OCH_2CH_2OCH_3$. The halogen atom is preferably a chlorine atom. The functional group capable of forming a chemical bond to the ultraviolet-curing resin is preferably $CH_2=CHCO-$, $CH_2=C(CH_3)CO-$, $CH_2=C(CF_3)-CO-$, $CF_2=C(CF_3)CO-$, $CH_2=CH-$ or I-.

The specific examples of the reactive compound are a monomer such as diethoxydivinylsilane, dimethoxydivinylsilane and 3-(N-allyl-N-methacryloyl)aminopropyltrimethoxysilane, and a (meth)acrylate polymer of the formula:

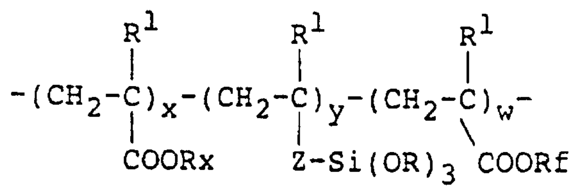

(I)

wherein each of $R^1$ is, the same or different, a hydrogen atom or a methyl group,
Rx is a hydrocarbon group having an unsaturated bond in a molecule,
Rf is a fluoroalkyl group,
R is a methyl, ethyl or propyl group,
Z is a single bond, or a divalent organic group comprising carbon, hydrogen and oxygen atoms,
x is the number of 2 to 1000, preferably 2 to 800,
y is the number of 1 to 1000, preferably 1 to 800, and
w is the number of 0 to 1000, preferably 0 to 800.

Specific examples of the Z group comprising carbon, hydrogen and oxygen atoms are $-(CH_2)_n-$,$-(CH_2)_n-(CF_2)_m-$ and $-COO(CH_2)_n-$wherein each of m and n is an integer of 1 to 10.

An amount of the reactive compound is generally 0.01 to 10, preferably 0.1 to 5 parts by weight per 100 parts by weight of the resin composition.

The resin composition according to the present invention preferably contains acrylic and/or methacrylic acid. Since (meth)acrylic acid acts as an auxiliary for the reactive compound, the addition of (meth)acrylic acid increases the bond strength between the core and cladding. An amount of (meth)acrylic acid is from 0.005 to 10, preferably 0.05 to 5 parts by weight per 100 parts by weight of the resin composition. When the amount is smaller than 0.005 part by weight, the effect as the auxiliary is not sufficient. When the amount is larger than 10 parts by weight, the optical fiber has low light transmittance.

The ultraviolet-curing resin may be a (meth)acrylate copolymer having a number average molecular weight of 50,000 to 5,000,000 (in terms of polystyrene) and an unsaturated bond in an ester side chain, of the formula:

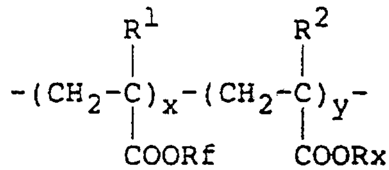

wherein each of $R^1$ and $R^2$ is a hydrogen atom or a methyl group,
Rf is a fluoroalkyl group,
Rx is a hydrocarbon group having an unsaturated bond,
x is the number of 1 to 5,000, preferably 1 to 1,000, and
y is the number of 1 to 5,000, preferably 1 to 1,000.

Rx may be a vinyl group, an allyl group, an acryl group, a methacryl group or an internal olefin. Rf may be

$-(CH_2)_a-(CF_2)_b-CF_3$

wherein a is 1 or 2, and b is from 2 to 6, or
a perfluoroalkyl group having 2 to 15 carbon atoms.

The polymer may contain a third component so as to improve heat resistance. Specific examples of the third component are isobornyl (meth)acrylate, dicyclopentanyl (meth)acrylate and adamantyl (meth)acrylate.

The ultraviolet-curing resin may be a (meth)acrylate copolymer having at least one fluorine atom which is preferably represented by the formula:

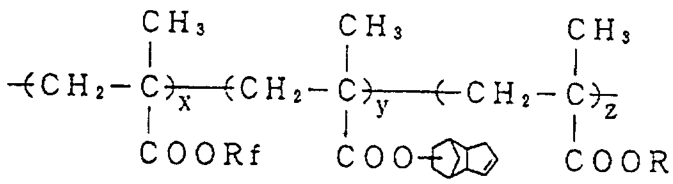

wherein Rf is a fluoroalkyl group,
R is an alkyl group,
x is the number of 1 to 5,000, preferably 1 to 1,000,
y is the number of 1 to 5,000, preferably 1 to 1,000, and
z is the number of 1 to 5,000, preferably 1 to 1,000.
Rf may be

$-(CH_2)_a-(CF_2)_b-CF_3$

wherein a is 1 or 2, and b is from 2 to 6, or a perfluoroalkyl group having 2 to 15 carbon atoms. R is preferably an alkyl group having 1 to 15 carbon atoms.

The ultraviolet-curing resin may be a polyurethane acrylate of the formula:

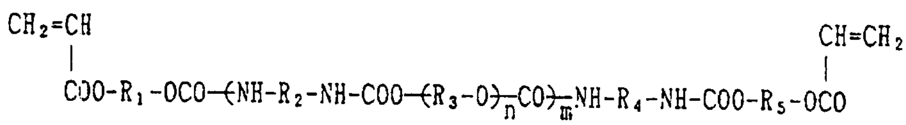

or

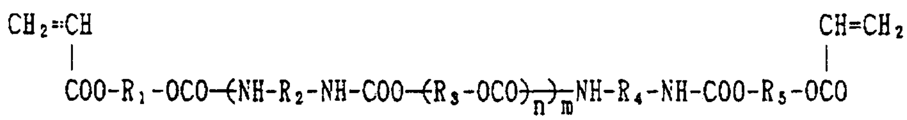

wherein $R^1$, $R^2$, $R^3$, $R^4$ and $R^5$ are the same or different and each an alkyl group or a fluoroalkyl group,
m is the number of 0 to 100, and
n is the number of 1 to 100. The polyurethane acrylate may contain at least one fluorine atom so as to obtain a suitable refractive index. The fluoroalkyl group may be

$-(CH_2)_a-(CF_2)_b-(CH_2)_a-$

wherein a is 1 or 2, and b is from 2 to 6, or a perfluoroalkyl group having 3 to 15 carbon atoms. The alkyl group may be an alkyl group having 1 to 15 carbon atoms.

The ultraviolet-curing resin may be a (meth)acrylic compound or a fluorinated (meth)acrylic compound.

The ultraviolet-curing resin preferably has a molecular weight of 1,000 to 5,000,000, preferably 1,000 to 1,000,000.

An amount of the ultraviolet-curing resin is generally from 90 to 99.99 parts by weight per 100 parts by weight of total amount of the reactive compound and the ultraviolet-curing resin. Alternatively, the amount of the ultraviolet-curing resin is generally from 5 to 95, preferably from 5 to 80, more preferably 10 to 70 parts by weight per 100 parts by weight of the resin composition.

The resin composition according to the present invention may further contain a photoinitiator. The photoinitiator is preferably a compound which easily generates a free radical by ultraviolet irradiation.

Specific examples of the photoinitiator are benzophenone, acetophenone, benzil, benzoin, benzoin methyl ether, benzoin isobutyl ether, benzyl dimethyl ketal, α,α'-azobisisobutyronitrile, benzoylperoxide, 1-hydroxyoyclohexyl phenyl ketone, 2,2-dimethoxy-2-phenylacetophenone and 2-hydroxy-2-methyl-1-phenylpropan-1-one. 1-Hydroxycyclohexyl phenyl ketone, 2,2-dimethoxy-2-phenylacetophenone and 2-hydroxy-2-methyl-1-phenylpropan-1-one are particularly preferable.

An amount of the photoinitiator is generally from 0.01 to 10, preferably from 0.05 to 5 parts by weight per 100 parts by weight of the resin composition.

The resin composition preferably has a viscosity of 100 to 10,000 cps so that the resin composition can be coated on the glass core so as to form a homogeneous and thin layer. The resin composition may contain a reactive diluent so as to control the viscosity of the resin composition. The reactive diluent may be a (meth)acrylic compound. Specific examples of the (meth)acrylic compound are methyl (meth)acrylate, cyclohexyl (meth)acrylate, isobornyl (meth)acrylate, ethylene glycol di(meth)acrylate, neopentyl glycol di(meth)acrylate and trimethylolpropane tri(meth)acrylate.

The reactive diluent may be a (meth)acrylic compound having at least one fluorine atom so as to control the refractive index of the cladding. Specific examples of such fluorinated (meth)acrylic compound are trifluoroethyl (meth)acrylate, tetrafluoropropyl (meth)acrylate, heptadecafluorodecyl (meth)acrylate, a compound of the formula:

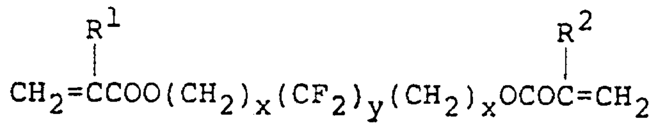

wherein each of $R^1$ and $R^2$ is a hydrogen atom or a methyl group,
x is the number of 1 to 2, and
y is the number of 2 to 6,
a compound of the formula:

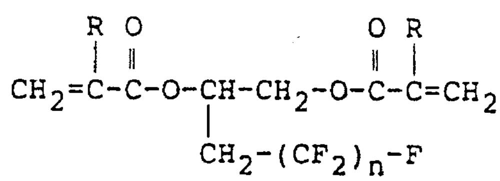

wherein each of R is, the same or different, a hydrogen atom or a methyl group, and
n is the number of 4 to 10, and
a compound of the formula:

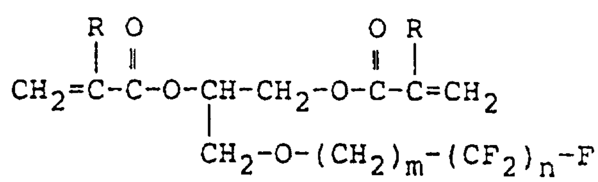

wherein each of R is, the same or different, a hydrogen atom or a methyl group,
m is the number of 1 to 2, and
n is the number of 4 to 10.

An amount of the reactive diluent is generally not larger than 94 parts by weight, preferably not larger than 89 parts by weight, more preferably from 20 to 89 parts by weight per 100 parts by weight of the resin composition.

The plastic clad optical fiber according to the present invention can be prepared by coating the resin composition on the core made of quart or optical glass by, for example, a die coating or spray coating method and then subjecting the resin composition to active light such as ultraviolet so as to cure the resin composition to form the cladding. A dose of the light is generally from 10 to 5,000 mJ/$cm^2$. A diameter of

the core is generally from 10 to 1,000 µm. A thickness of the cladding is generally from 1 to 100, preferably from 5 to 50 µm.

## PREFERRED EMBODIMENT OF THE INVENTION

The present invention will be illustrated by the following Examples which do not limit the present invention.

### Examples 1 to 4 and Comparative Examples 1 and 2

Immediately after drawing a quartz glass rod to form a core fiber having an outer diameter of 200 µm, a resin composition having components indicated in Table 1 was coated on the core fiber and cured by ultraviolet irradiation to obtain a plastic clad optical fiber having an outer diameter of 230 µm.

When a crimp type connector was connected with the plastic clad optical fiber, pull-out strength between the fiber and the connector at 25°C was as shown in Table 2.

Table 1

| Example No. | | 1 | 2 | Com. 1 | 3 | 4 | Com. 2 |
|---|---|---|---|---|---|---|---|
| Polymer | (A) | 10 | 10 | 10 | — | — | — |
| | (B) | — | — | — | 60 | 59.7 | 60 |
| $CH_2=CHCOO(CH_2)_2(CF_2)_7CF_3$ | | 65 | 64.7 | 65 | — | — | — |
| $CH_3$<br>$CH_2=CHCOOCH_2CCH_2OCOCH=CH_2$<br>$CH_3$ | | 15 | 15 | 15 | — | — | — |
| $CH_3CH_2C(CH_2OCOCH=CH_2)_3$ | | 9 | 9 | 9 | — | — | — |
| $CH_2=CHCOOCHCH_2OCOCH=CH_2$<br>$CH_2(CF_2)_7CF_3$ | | — | — | — | 24 | 24 | 24 |
| $CH_2=CHCOOCHCH_2OCOCH=CH_2$<br>$CH_2(CF_2)_5CF_3$ | | — | — | — | 15 | 15 | 15 |
| 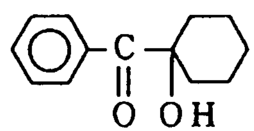 | | 0.5 | 0.5 | 0.5 | 0.5 | 0.5 | 0.5 |
| $CH_2=CCON(CH_2)_3Si(OCH_3)_3$<br>$CH_3CH_2CH=CH_2$ | | 0.5 | 0.5 | — | 0.5 | 0.5 | — |
| $CH_2=CHSi(OCH_3)_3$ | | — | — | 0.5 | — | — | 0.5 |
| $CH_2=CHCOOH$ | | — | 0.3 | — | — | 0.3 | — |

Note:

Polymer (A)

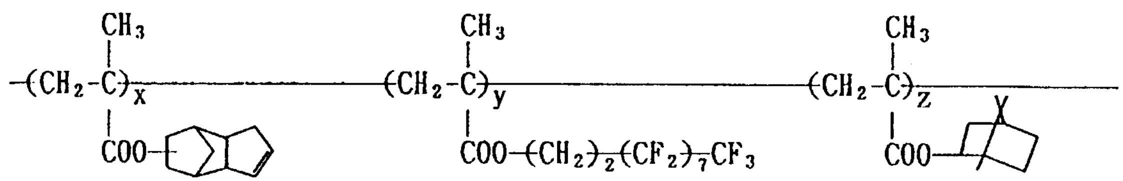

x:y:z=1:8:1

Polymer (B)

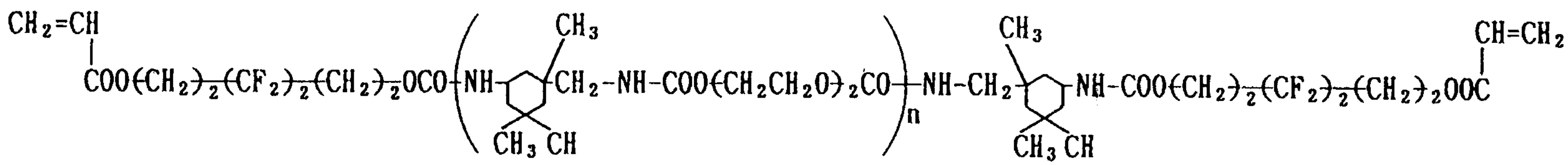

(n=10)

Table 2

| Example No. | 1 | 2 | Com.1 | 3 | 4 | Com.2 |
|---|---|---|---|---|---|---|
| Pull-out strength (kg) | 3.0 | 4.1 | 2.2 | 3.1 | 4.3 | 2.4 |

The plastic optical fiber according to the present invention has high bond strength between the core and the cladding. Accordingly, the optical fiber according to the present invention has lower possibility of pull-out between the fiber and the connector than conventional optical fibers when the optical fiber connected with the connector is carelessly handled.

**Claims**

1. A resin composition comprising an ultraviolet-curing resin, and a reactive compound that has at least one silicon atom to which an alkoxy group or a halogen atom is bonded, and at least two functional groups capable of forming a chemical bond to the ultraviolet-curing resin in a molecule.

2. The resin composition according to claim 1, which further contains (meth)acrylic acid.

3. The resin composition according to claim 1, which further contains a photoinitiator.

4. The resin composition according to claim 1, which further contains a reactive diluent.

5. The resin composition according to claim 4, wherein the reactive diluent is a (meth)acrylic compound or a fluorinated (meth)acrylic compound.

6. The resin composition according to claim 1, wherein the alkoxy group in the reactive compound is $-OCH_3$, $-OCH_2CH_3$, $-OCH_2CH_2CH_3$ or $-OCH_2CH_2OCH_3$.

7. The resin composition according to claim 1, wherein the halogen atom in the reactive compound is a chlorine atom.

8. The resin composition according to claim 1, wherein the functional group in the reactive compound is $CH_2=CHCO-$, $CH_2=C(CH_3)CO-$, $CH_2=C(CF_3)CO-$, $CF_2=C(CF_3)CO-$, $CH_2=CH-$ or I-.

9. The resin composition according to claim 1, wherein the reactive compound is a monomer selected from the group consisting of diethoxydivinylsilane, dimethoxydivinylsilane and 3-(N-allyl-N-methacryloyl)aminopropyltrimethoxysilane, or a (meth)acrylate polymer of the formula:

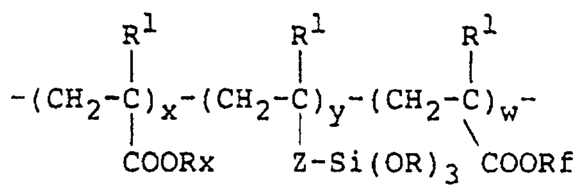

(I)

wherein each of $R^1$ is, the same or different, a hydrogen atom or a methyl group,
Rx is a hydrocarbon group having an unsaturated linkage in a molecule,
Rf is a fluoroalkyl group,
R is a methyl, ethyl or propyl group,
Z is a single bond, or a divalent organic group comprising carbon, hydrogen and oxygen atoms,
x is the number of 2 to 1000,
y is the number of 1 to 1000, and
w is the number of 0 to 1000.

10. The resin composition according to claim 1, wherein the ultraviolet-curing resin is selected from the group consisting of a (meth)acrylate polymer, a fluorinated (meth)acrylate polymer, a polyurethane acrylate, a (meth)acrylic compound and a fluorinated (meth)acrylic compound.

**11.** The resin composition according to claim 1, wherein the ultraviolet-curing resin has repeating units derived from at least one monomer selected from the group consisting of isobornyl (meth)acrylate, dicyclopentanyl (meth)acrylate and adamantyl (meth)acrylate.

**12.** The resin composition according to claim 1, wherein an amount of the reactive compound is from 0.01 to 10 parts by weight and an amount of the ultraviolet-curing resin is from 90 to 99.99 parts by weight.

**13.** The resin composition according to claim 2, wherein an amount of (meth)acrylic acid is from 0.005 to 10 parts by weight per 100 parts by weight of the resin composition.

**14.** The resin composition according to claim 3, wherein an amount of the photoinitiator is from 0.01 to 10 parts by weight per 100 parts by weight of the resin composition.

**15.** The resin composition according to claim 4, wherein an amount of the reactive diluent is not larger than 94 parts by weight per 100 parts by weight of the resin composition.

**16.** A plastic clad optical fiber comprising a core made of quartz or optical glass and a cladding made of a plastic having a lower refractive index than the core, wherein the cladding is made of a cured material of a resin composition comprising an ultraviolet-curing resin, and a reactive compound that has at least one silicon atom to which an alkoxy group or a halogen atom is bonded, and at least two functional groups capable of forming a chemical bond to the ultraviolet-curing resin in a molecule.

**17.** The optical fiber according to claim 16, wherein the resin composition further contains (meth)acrylic acid.

**18.** The optical fiber according to claim 16, wherein the resin composition further contains a photoinitiator.

**19.** The optical fiber according to claim 16, wherein the resin composition further contains a reactive diluent.

**20.** The optical fiber according to claim 19, wherein the reactive diluent is a (meth)acrylic compound or a fluorinated (meth)acrylic compound.

**21.** The optical fiber according to claim 16, wherein the alkoxy group in the reactive compound is $-OCH_3$, $-OCH_2CH_3$, $-OCH_2CH_2CH_3$ or $-OCH_2CH_2OCH_3$.

**22.** The optical fiber according to claim 16, wherein the halogen atom in the reactive compound is a chlorine atom.

**23.** The optical fiber according to claim 16, wherein the functional group in the reactive compound is $CH_2=CHCO-$, $CH_2=C(CH_3)CO-$, $CH_2=C(CF_3)CO-$, $CF_2=C(CF_3)CO-$, $CH_2=CH-$ or I-.

**24.** The optical fiber according to claim 16, wherein the reactive compound is a monomer selected from the group consisting of diethoxydivinylsilane, dimethoxycivinylsilane and 3-(N-allyl-N-methacryloyl)-aminopropyltrimethoxysilane, or a (meth)acrylate polymer of the formula:

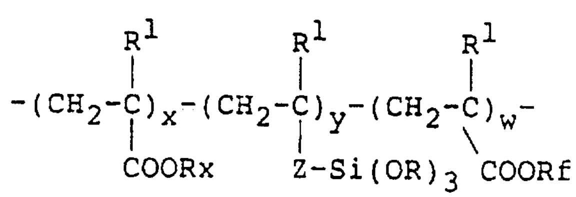

(I)

wherein each of $R^1$ is, the same or different, a hydrogen atom or a methyl group,
Rx is a hydrocarbon group having an unsaturated linkage in a molecule,
Rf is a fluoroalkyl group,
R is a methyl, ethyl or propyl group,

Z is a single bond, or a divalent organic group comprising carbon, hydrogen and oxygen atoms,
x is the number of 2 to 1000,
y is the number of 1 to 1000, and
w is the number of 0 to 1000.

**25.** The optical fiber according to claim 16, wherein the ultraviolet-curing resin is selected from the group consisting of a (meth)acrylate polymer, a fluorinated (meth)acrylate polymer, a polyurethane acrylate, a (meth)acrylic compound and a fluorinated (meth)acrylic compound.

**26.** The optical fiber according to claim 16, wherein the ultraviolet-curing resin has repeating units derived from at least one monomer selected from the group consisting of isobornyl (meth)acrylate, dicyclopentanyl (meth)acrylate and adamantyl (meth)acrylate.

**27.** The optical fiber according to claim 16, wherein an amount of the reactive compound is from 0.01 to 10 parts by weight and-an amount of the ultraviolet-curing resin is from 90 to 99.99 parts by weight.

**28.** The optical fiber according to claim 17, wherein an amount of (meth)acrylic acid is from 0.005 to 10 parts by weight per 100 parts by weight of the resin composition.

**29.** The optical fiber according to claim 18, wherein an amount of the photoinitiator is from 0.01 to 10 parts by weight per 100 parts by weight of the resin composition.

**30.** The optical fiber according to claim 19, wherein an amount of the reactive diluent is not larger than 94 parts by weight per 100 parts by weight of the resin composition.

European Patent Office

# EUROPEAN SEARCH REPORT

Application Number

EP 92 11 7192

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | CHEMICAL ABSTRACTS, vol. 24, no. 111, 26 April 1989, Columbus, Ohio, US; abstract no. 215701a, OKUDA YASUHIRO ET AL. 'SILICON COMPOUND CONTAINING ADHESIVES FOR BONDING CORE AND CLAD OF OPTICAL FIBER' * abstract * & DATABASE WPIL Derwent Publications Ltd., London, GB; AN 89-168729 & JP-A-1 109 309 (SUMITOMO ELEC IND KK) 26 April 1989 * abstract * | 1,4-6,8, 10,16, 19-21, 23,25 | C08F299/00 C08F299/06 C08F265/04 C03C25/02 //(C08F265/04, 230:08) |
| A | EP-A-0 250 996 (DAIKIN INDUSTRIES LTD) * claims * * example 3 * | 1-30 | |
| A | US-A-4 810 759 (ROSE A. RYNTZ) * claims * * column 8, line 2 - column 8, line 55 * | 1-15 | |

TECHNICAL FIELDS SEARCHED (Int. Cl.5 )

C08F
C03C

The present search report has been drawn up for all claims

| Place of search | Date of completion of the search | Examiner |
|---|---|---|
| THE HAGUE | 25 JANUARY 1993 | PERSSON E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document